# EUROPEAN PATENT SPECIFICATION

(11) **EP 3 948 935 B1**
(45) Date of publication and mention of the grant of the patent: **07.06.2023**
(21) Application number: 20717947.4
(22) Date of filing: 19.03.2020
(51) Int. Cl.: H01L 21/02, H01L 21/683

(54) **GRAPHENE AND TWO-DIMENSIONAL MATERIALS TRANSFER METHOD BY USING FREE-STANDING BILAYER POLYMERIC MEMBRANE**
VERFAHREN ZUR ÜBERTRAGUNG VON GRAPHEN UND ZWEIDIMENSIONALEN MATERIALIEN UNTER VERWENDUNG EINER FREISTEHENDEN ZWEISCHICHTIGEN POLYMERMEMBRAN
GRAPHÈNE ET PROCÉDÉ DE TRANSFERT DE MATÉRIAUX BIDIMENSIONNELS AU MOYEN D'UNE MEMBRANE POLYMÈRE BICOUCHE AUTOPORTANTE

(30) Priority: 03.04.2019 IT 201900005030
(43) Date of publication of application: 09.02.2022
(73) Proprietor: Fondazione Istituto Italiano di Tecnologia, 16163 Genova (IT); Consorzio Nazionale Interuniversitario per le Telecomunicazioni, 43124 Parma (IT)
(72) Inventor: COLETTI, Camilla, 16163 Genova (IT); GIAMBRA, Marco Angelo, 43124 Parma (IT); MISEIKIS, Vaidotas, 16163 Genova (IT); ROMAGNOLI, Marco, 43124 Parma (IT)
(74) Representative: Budde Schou A/S
(86) International application number: PCT/IB2020/052501
(87) International publication number: WO 2020/201876

(56) References cited:
- DE LA ROSA CÉSAR J LOCKHART ET AL: "Frame assisted HO electrolysis induced Hbubbling transfer of large area graphene grown by chemical vapor deposition on Cu", APPLIED PHYSICS LETTERS, A I P PUBLISHING LLC, US, vol. 102, no. 2, 14 January 2013 (2013-01-14), pages 22101-22101, XP012168803, ISSN: 0003-6951, DOI: 10.1063/1.4775583 [retrieved on 2013-01-15]
- JOOHO LEE ET AL: "Tension assisted metal transfer of graphene for Schottky diodes onto wafer scale substrates", NANOTECHNOLOGY, IOP, BRISTOL, GB, vol. 27, no. 7, 20 January 2016 (2016-01-20), page 75303, XP020299529, ISSN: 0957-4484, DOI: 10.1088/0957-4484/27/7/075303 [retrieved on 2016-01-20]

## Description

### TECHNICAL FIELD

The present invention relates to the electronics field and, in particular, to methods and products for transferring graphene and other two-dimensional materials. Specifically, the present invention relates to a method for transferring a two-dimensional material, precisely graphene, onto a target substrate by using free-standing bilayer polymeric membrane.

The invention also relates to a multilayer product comprising a free-standing bilayer polymeric membrane, suitable for transferring a two-dimensional material.

The present invention finds advantageous applications in the fields of electronics (for example, high-speed electronics and low-power electronics), of photonics, of optoelectronics, of spintronics and of biosensors, for transferring graphene on wafer-scale keeping it mechanically intact and without transfer residues; a preferred application is for the realization of telecom and datacom modulators and detectors.

### STATE OF ART

Graphene is a two-dimensional material, or 2D material, that has aroused a great interest since its recent discovery, particularly in the field of electronics and photonics. Graphene has unique properties: it is ultra-thin, it is flexible, it has a high mechanical strength, it is an excellent thermal and electrical conductor, it resists at high temperatures and at pH variations, it maintains its properties unaltered for a wide temperature range.

Thanks to its two-dimensional nature, graphene can be integrated into consolidated technologies without having to make significant changes in the process flow.

In particular, the possibility of transferring graphene from the source substrate (typically, a copper sheet) on any target substrate makes it suitable for various applications, such as photonics, electronics and biosensors.

On the other hand, the quality of the final material strongly depends on the methods used to delaminate the graphene from the copper sheet and to laminate it on a target substrate.

To date, the identification of a method for transferring graphene on wafer-scale, while keeping it mechanically intact and without transfer residues, represents the principal obstacle for the adoption of this two-dimensional material in actual applications. According to the prior art, the transfer of graphene on wafer-scale is usually carried out by means of 1) transfer technique in chemical bath, 2) semi-dry transfer technique using a PMMA membrane and 3) semi-dry transfer technique using a mold made of polydimethylsiloxane PDMS.

However, each of these techniques presents inherent lacks, which are detrimental to the final quality of the transferred graphene.

All the aforesaid techniques are described in detail, with the related inherent technical problems, in the publication Kang et al. review Nanoscale 2012, 4, 5527 "Graphene transfer: key for applications".

The transfer in chemical bath is the most commonly used graphene transfer technique; it is based on the release of the graphene layer by means of chemical etching of the copper substrate and subsequent transfer of the graphene membrane to the target wafer (target substrate) through an aqueous medium; in general, many rinsing steps are performed to remove the residues of the chemical etching, but some contamination remains inevitably trapped in the solution between the graphene and the target substrate; the chemical contamination persists after the transfer and, more generally, this method can not be considered suitable for processes on wafer-scale due to the softness of the material.

The semi- dry transfer is instead carried out by electrochemical delamination, using a PMMA membrane; in general, the levels of contamination are limited by avoiding aggressive chemicals, but the graphene monolayer is subjected to mechanical damages due to the fragility of the PMMA membrane; the mechanical stress can be transferred from the PMMA membrane, used for the transfer, to the two-dimensional layer, which can be damaged with tears and breaks; therefore, also this method can not be considered suitable for processes on wafer-scale, due to the softness of the PMMA membrane layer.

The third method used regards the semi-dry transfer by means of a mold made of polydimethylsiloxane PDMS; this method provides a rigid support for graphene, but the release of the functional layer from the mold can be problematic; in particular, graphene can be released from the mold by applying heat and pressure, but this can easily lead to the break of the graphene crystals due to the differences of the expansion coefficients of graphene and PDMS.

In the prior art there are different documents relating to the transfer processes.

In the scientific publication Suk et al. 2011, ACS Nano "Transfer of CVD-grown monolayer graphene onto arbitrary substrates", reproducible dry and in chemical bath transfer techniques are described to improve the transfer of large area monolayer graphene grown on copper sheets by chemical vapor deposition (CVD). In particular, the dry transfer technique uses a frame made of polydimethylsiloxane PDMS that adheres to the polymethylmethacrylate PMMA applied on the graphene film. The polydimethylsiloxane frame is used to support the graphene / PMMA film, allowing the graphene / PMMA film to be removed by the etching fluid the copper and to be dried. The PDMS / PMMA / graphene composite is placed on the target substrate, covering the wells. The substrate is heated above the glass transition temperature Tg of the PMMA. The heat treatment allows the wavy and rough PMMA / graphene film to completely adhere to the target substrate. After the heat treatment, the adhesion of graphene to the substrate is strong enough to be able to detach the block of PDMS without delaminate the PMMA / graphene film. The PMMA is then thermally removed in an oven at 350 °C with Argon Ar and Hydrogen H₂ for two hours, without using any solvent. The final result is a reproducible dry transfer technique.

The main limits and disadvantages of the aforesaid technical solution, namely of a membrane consisting of a single layer of PMMA, reside primarily in the ineffectiveness in annulling the transmission of stresses to the underlying graphene layer.

In fact, the aforesaid technical solution, though presenting a membrane consisting of a PDMS frame and a PMMA layer, does not show instead intermediate polymeric layers, which are necessary for an effective mechanical support of the membrane and for a consequent reduction of the stresses transferred to the two-dimensional material layer. Therefore, the aforesaid technical solution results to be unsuitable for obtaining two-dimensional functional layers of high-quality, free from defects and/or damages due to the transfer and free from contamination.

The same Inventors of the present invention, in the scientific publication Miseikis et al. 2017, 2D Materials "Deterministic patterned growth of high-mobility large-crystal graphene: a path towards wafer-scale integration", describe a rapid deterministic growth technique of large graphene crystals by chemical vapor deposition (CVD) using pre-treated copper sheets and adding chromium nucleation sites. Graphene is transferred onto the target substrate by means of a semi-dry transfer free from contamination. Copper sheets with sown graphene crystals are coated with a thin support layer of PMMA and left to dry at environmental conditions. A semi-rigid frame made with Kapton adhesive tape is then applied around the perimeter of the support. The PMMA membrane with the graphene crystal matrix is detached from the copper substrate by electrochemical delamination using 1M NaOH as the electrolyte. The electrochemical reaction is performed by applying a voltage of 2.4 V between the support and a copper counter- electrode. The free-standing membrane of PMMA / graphene, stretched by the Kapton frame, is removed by the electrolyte, rinsed with water and dried at environmental conditions; subsequently, it is connected to a micromanipulator and aligned to the substrate. The membrane is brought in close contact with the target substrate, which was then heated to 100 °C in order to improve the graphene adhesion. The PMMA support film is then removed by immersion into acetone. The transfer, which occurs with reduced contamination and is aligned, provides a significant improvement for the adoption of CVD graphene in manufacturing on wafer-scale.

The main limits and disadvantages of the aforesaid technical solution, namely of a membrane consisting of a single layer of PMMA, reside primarily in the ineffectiveness of annulling the transmission of stresses to the underlying graphene, in the complexity of preparing the Kapton frame, which is made manually and which requires fastening with glue of the frame, in the fact that the sole bath in acetone does not guarantee a perfect cleaning of the surface and in the fact that the Kapton glue residues remain in solution.

In fact, the aforesaid technical solution, though presenting a PMMA membrane, the electrochemical delamination of graphene from the growth substrate in a solution of 1M NaOH at an applied voltage of -2.4V and the bath in acetone for removing the polymeric layers, does not show instead intermediate polymeric layers, which are necessary for an effective mechanical support of the membrane and for a consequent reduction of the stresses transferred to the two-dimensional material layer, as well as the possible further immersion in AR600-71 for removing any contamination. Therefore, the aforesaid technical solution results to be unsuitable for obtaining two-dimensional functional layers of high-quality, free from defects and/or damages due to the transfer and free from contamination.

Also in the patent literature methods for transferring graphene layers are present. The US Patent application No. US 2016/0137507 A1 refers to a method for transferring graphene using the determination assisted by water vapor of a graphene film made to grow with CVD on a copper sheet. Using a polymeric film as a support layer, it was noticed that graphene can be directly removed from the copper sheet as a result of intercalated water at the graphene-Cu interface, by means of a dry transfer method. The delaminated graphene films are continuous on a large surface. Such nondestructive method also works for transferring graphene made to grow on a single copper crystal without sacrificing the expensive crystal, thereby offering the possibility of producing high quality graphene and reusing the substrate. The copper sheet and the single crystal can be used repeatedly for many times, which may reduce the cost of the graphene synthesis and it is more environment friendly. The proposed method offers the advantages of a high efficiency, of industrial scalability, of the minimum use of chemicals and of the reusability of the copper sheet in multiple cycles of growth and delamination. In this process, in order to improve the adhesion of the polymer to graphene, both pressure and heat have been employed, in particular a pressure of 0.1-1.0 Kgf/cm² and a temperature of 150-200 °C for 5-30 minutes. A high temperature (150-200 °C) was further applied in order to improve the adhesion between the graphene and the target substrate for 3-10 minutes. According to this application, the polymeric film can be made of polymethylmethacrylate PMMA, polycarbonate PC, polypropylene PP and polydimethylsiloxane PDMS.

The main limits and disadvantages of the aforesaid technical solution, namely of a single layer of PC, reside primarily in the ineffectiveness of annulling the transmission of stresses to the underlying graphene, especially with high temperature and pressure values applied to the system.

In fact, the aforesaid technical solution, refers to a single polymeric layer and does not show a membrane.

Therefore, the aforesaid technical solution results to be unsuitable for obtaining two-dimensional functional layers of high-quality, free from defects and/or damages due to the transfer and free from contamination, due to the use of a single polymeric layer and high temperature and pressure values.

The US Patent application No. US 2014/0284303 A1 refers to a method for transferring graphene which employs a roll-to-roll apparatus. In detail, a graphene layer is formed on a catalyst metal and a support body is formed on the graphene layer, creating a stacked structure. Such structure, thanks to the roll-to-roll apparatus, is conveyed into a container that stores a liquid for removing the catalyst metal. The metal is removed by a water etching process. The assembly support body / graphene is then conveyed in a roll-to-roll way in a direction along which the target substrate is located, where the polymeric support body has the function to maintain the shape of graphene and to avoid the damage thereof by supporting the functional layer during the transfer. Such support body can be removed using an organic solvent, for example acetone. Such support body can be chosen from polymethylmethacrylate PMMA, polycarbonate PC, polypropylene PP, polydimethylsiloxane PDMS and other polymers.

The main limits and disadvantages of the aforesaid technical solution reside primarily in the fact that, by providing a single polymeric layer, does not allow a transfer without breaks and tears. Moreover, the polymeric membrane according to the aforesaid technical solution can consist in at least one of the polymers chosen from PMMA, PC, PP, PDMS and other polymers while the possibility to use PPC is not mentioned. Moreover the aforesaid technical solution does not suggest how to structure the various layers and does not report any evidence about the possible synergy of properties that the various layers would play for the purpose of the final transfer of the two-dimensional material: consequently, there is no a practical indication for performing a transfer of graphene free from contaminations and induced stresses. Finally the possibility of a bath in AR600-71 to remove possible contaminants is not mentioned, but only a bath in acetone is cited.

In fact, the aforesaid technical solution refers to a single polymeric layer and does not show a membrane.

Therefore, the aforesaid technical solution results to be unsuitable for performing a transfer of a two-dimensional material free from breaks and defects.

The US Patent application No. US 2018/0288910 A1 describes a method for the production of electronic devices that exploits a large-scale transfer method; such method provides to arrange, by "spin coating", a transfer film (chosen from PDMS, PMMA and PPC) on an assembly of functional layers, arranged on a substrate and separated from each other; a support frame is subsequently fixed on the transfer film, which frame presents a series of cavities separated from each other; then the transfer film and the functional layers are removed from the substrate and the system is placed on a target substrate; then the support frame is detached and the transfer film is removed from the target substrate; the removal from the substrate takes place by immersion in a NaOH solution; the system consisting of the transfer film and the support frame is then immersed in extra pure water after delamination from the substrate, for a cleaning step; the support frame is then mechanically removed, also with the aid of high temperature, in the range 150-180 °C; the transfer film is finally removed in acetone or chloroform.

The main limits and disadvantages of the aforesaid technical solution reside primarily in the fact that, during the removal step of the support frame, transfer of stresses to the functional layers can occur.

In fact, the aforesaid technical solution, though presenting a transfer polymeric film and a support frame, does not present intermediate polymeric layers, which are necessary for avoiding transfer of stresses to the functional layers; moreover, the aforesaid technical solution does not provide for heating of the target substrate to increase adhesion as well as possible further baths in AR600-71 for removing any residual contamination.

Therefore, the aforesaid technical solution results unsuitable, due to the use of a single polymeric layer, for transfer functional layers of two-dimensional materials free from residual stresses and breaks.

The scientific publication "The hot pick-up technique for batch assembly of van der Waals heterostructures", Pizzocchero et al. 2016, Nature communications describes the use of a PPC and PDMS membrane for dry collection and release of small expanded flakes; the property of the PPC exploited in this document is the controlled softening of the polymer during heating.

The main limits and disadvantages of the aforesaid technical solution reside primarily in the fact that it does not allow the transfer of functional layers of two- materials dimensional and in the fact that it presents a membrane of only PPC and PDMS, which would not guarantee the conservation of the graphene properties once transferred. In fact, the aforesaid technical solution refers to the use of a PPC and PDMS membrane for dry collection and release of small expanded flakes.

Therefore, the aforesaid technical solution results to be unsuitable for carrying out a transfer as much as possible free from induced stresses and breaks of functional layers of two-dimensional materials free from contamination.

The mentioned and above-commented documents - due to the use of a structure mainly consisting in a single polymeric layer combined with a support frame, due to the polymers removal modes aiding the transfer and due to the type of the materials used - propose ineffective technical solutions for the transfer of layers of two-dimensional materials that conserve the initial properties and that are free from final contamination; only the US Patent application no. US 2014/0284303 A1, which is the only one to consider the possibility of having a multilayer polymeric membrane, does not actually provide information of any kind relating to the structure of the membrane itself and, moreover, it does not specify what particular properties of the corresponding chosen polymers are found to be fundamental to allow a transfer of graphene having the same final properties achieved, instead, by the present invention.

Further transfer methods are described in "Frame assisted H2O electrolysis induced H2 bubbling transfer of large area graphene grown by chemical vapor deposition on Cu" by César J. Lockhart de la Rosa et al., Applied Physics Letters 102, 2013 and "Tension assisted metal transfer of graphene for Schottky diodes onto wafer scale substrates" by Jooho Lee et al. Nanotechnology 27, 2016.

Therefore, up to now it remains unsatisfied the need of having a suitable method for carrying out the transfer of two-dimensional materials without that, during the transfer, an excessive pressure on the two-dimensional material occurs, thus minimizing the risk of tears and breaks.

Furthermore, up to now it remains unsatisfied the need of having a suitable method for carrying out the transfer of two-dimensional materials that allows a perfect delamination of graphene without copper contamination.

Furthermore, up to now it remains unsatisfied the need of having a suitable method for carrying out the transfer of two-dimensional materials that allows an aligned lamination free from damages to single graphene crystals on target substrates, so that it is compatible with wafer-scale processing.

Finally, up to now it remains unsatisfied the need of having a multilayer product and a suitable method for carrying out the transfer of two-dimensional materials.

A method for transferring two-dimensional materials, and a corresponding multilayer product, able to minimize the risk of tears and breaks, to allow a delamination of the two-dimensional material free from copper contamination and to allow an aligned lamination free from damages of the single graphene crystals on target substrates, would satisfy the needs of several applications, in particular those requiring wafer-scale processing such as, for example, electronics, photonics, optoelectronics and spintronics.

The present invention, which relates to such a method for transferring two-dimensional materials and the corresponding multilayer product, aims to satisfy the aforesaid needs.

In particular, the present invention aims to solve the technical problem of carrying out the transfer of two-dimensional materials without that, during the transfer, an excessive pressure on the two-dimensional material occurs, in order to minimize the risk of tears and breaks though maintaining the high quality of the starting material. Furthermore, the present invention aims to solve the technical problem of carrying out the transfer of two-dimensional materials with a perfect graphene delamination free from copper contamination.

Furthermore, the present invention aims to solve the technical problem of carrying out the transfer of two-dimensional materials with an aligned lamination free from damages to the single graphene crystals on target substrates.

In summary therefore, at present, as far as the Inventors know, there are not known solutions that allow to carry out the transfer of two-dimensional materials, specifically of graphene, compatibly with the wafer-scale processing.

Therefore, the transfer method of two-dimensional materials and the corresponding multilayer product according to the present invention aim to remedy these lacks.

### OBJECTS AND SUMMARY OF THE INVENTION

It is an object of the present invention to overcome the drawbacks of the prior art linked with the transfer of two-dimensional materials, specifically of graphene.

In particular, it is an object of the present invention to overcome the drawbacks of the prior art linked with the transfer of two-dimensional materials, specifically og graphene, in wafer-scale processing.

These objects are achieved with the transfer method of two-dimensional materials and the corresponding multilayer product according to the present invention that, advantageously and thanks to the presence of a free-standing bilayer polymeric membrane, allow the transfer of the two-dimensional material on a target substrate without tears and breaks, without contamination and with a perfect alignment.

The transfer method of two-dimensional materials and the corresponding multilayer product according to the present invention for the first time, as far as the Inventors know, allow to carry out the transfer without exerting an excessive pressure on the two-dimensional material, thus minimizing the risk of breaks.

The invention aims to solve the problem of the thermal release of stresses in the two-dimensional material, which is the main cause of cracks and tears ruining the quality of the transferred layer.

In the conventional approaches the adopted polymer, such as PDMS, undergoes a thermal expansion that is directly transferred into the material; in the case of PMMA, a thin layer (for example, of approximately 100 nm) must be used to allow the graphene visibility in transparency regime, which is too fragile to be handled on wafer-scale.

The combination of two polymers and of an elastomeric frame allows to take the free-standing membrane without inducing a mechanical stress on it and, in consequence, on the material two-dimensional.

The polymer in contact with the two-dimensional material must have a high thermal resistance while the intermediate polymer has the main characteristic to be mechanically resistant and to keep the membrane integrity on a large scale simultaneously reducing the transfer of mechanical stresses from the elastomer.

The intermediate polymer, i.e. PPC, has been used in the past in contact with graphene for the dry collection and release of small expanded flakes (see the above-mentioned publication "The hot pick-up technique for batch assembly of van der Waals heterostructures", Pizzocchero et al. 2016, Nature communications); however, in this publication the property of the PPC exploited was not the mechanical resistance but rather the controlled softening of the polymer during heating.

The elastomeric frame can be prepared in any size required, allowing flexibility of transfer; PDMS or a similar elastomeric frame can be easily attached to the sacrificial substrate coated with polymer without leaving any residue after the transfer.

One of the main advantages in the use of PDMS, contrary to the Kapton tapes or adhesives commonly used in the prior art, is the absence of glue, and then its cleanliness as it does not leave residues; moreover, PDMS is transparent and therefore easier to align on the receiving substrate; moreover, its use is simpler than, for example, Kapton as it can be shaped thanks to the molds and it does not require a uncomfortable manual preparation, such as the cut.

If used with a rigid support layer in PPC or the like, the risk of damages to the two-dimensional material is greatly reduced, with a greater percentage of transferred material with high quality.

The adhesion of the material two-dimensional to the target substrate can be improved by heating the substrate safely up to 105 °C, well above the glass transition temperature of PPC (37 °C) or of polymers with similar mechanical characteristics. Compared to the existing solutions, the present invention has, as advantages:
- the reduction of the risk of tear and damage of the two-dimensional material;
- the resistance to temperature;
- the removal in common solvents without leaving significant residues;
- the precise alignment to the target substrate and without damage of the crystals of the two-dimensional material;
- the delamination of the two-dimensional material free from copper contamination;
- the possibility of a wafer-scale processing;
- the high-performance, proven by the statistical evaluation of electrical and optoelectronic measurements and of the Raman spectroscopy;
- the applicability to a wide range of two-dimensional materials such as, for example, graphene, hexagonal boron nitride h-BN, transition metals dichalcogenides TMD and X-enes.

Specifically, the aforesaid and other objects and advantages of the invention, as will become apparent from the following description, are achieved through a method according to claim 1.

Preferred embodiments and variants of the method according to the present invention form the object of the dependent claims 2 to 7.

Another independent aspect of the present invention relates to a multilayer product and forms the object of claim 8.

Preferred embodiments and variants of the multilayer product according to the present invention form the object of the dependent claims 9 and 10.

It is understood that all the appended claims form an integral part of the present description and that each of the technical features claimed therein is possibly independent and autonomously usable with respect to other aspects of the invention. It will be immediately evident that countless changes (for example relevant to shape, sizes, arrangements and parts with equivalent functionalities) to what described could be brought without departing from the scope of invention as claimed in the appended claims.

Advantageously, the technical solution according to the present invention allows:
- transferring monocrystals of two-dimensional materials intact, low-doped, non-deformed and with high mobility in a well-defined scheme;
- maintaining the electronic properties - such as mobility of the bearers carrier, surface resistivity and density of the starting doping carrier - essential for the use in electronics, photonics, optoelectronics and spintronics;
- creating modulators and detectors for telecom and datacom applications with record performances;
- achieving the compatibility with the wafer-scale processing;
- obtaining an easy scalability for multiple frames and for an automated transfer system ("stamping transfer") repetitive to cover wide areas.

Further advantageous features will appear more evident from the following description of preferred but non-exclusive embodiments, provided by way of pure and non-limiting example.

### BRIEF DESCRIPTION OF THE DRAWINGS

The present invention will be described hereinbelow by means of some preferred embodiments, given by way of non-limiting example, with reference to the attached drawings. These drawings illustrate different aspects and examples of the present invention and, where appropriate, similar structures, components, materials and/or elements in different figures are denoted by similar reference numbers.
FIG. 1 is a flowchart of the method for transferring graphene and two-dimensional materials by means of a free-standing bilayer polymeric membrane according to the present invention;
FIG. 2 is a schematic representation of the multilayer product according to the present invention;
FIG. 3A shows an optical microscope image of graphene transferred according to the prior art;
FIG. 3B is an enlargement of FIG. 3A;
FIG. 3C shows an optical microscope image of graphene transferred according to the present invention;
FIG. 4A shows an optical microscope image of a matrix of single crystals of graphene grown on the sacrificial copper substrate according to the present invention;
FIG. 4B shows an optical microscope image of a delaminated matrix of crystals of graphene in contact with the membrane according to the present invention;
FIG. 4C shows an optical microscope image of a matrix of crystals transferred onto the target substrate according to the present invention;
FIG. 5 shows an optical microscope image of the h-BN layer in contact with the transfer membrane according to the present invention;
FIG. 6 is a Raman spectrum of a commercial h-BN after the transfer according to the present invention;
FIG. 7 is a picture of the transfer bilayer polymeric membrane with the elastomeric support according to the present invention;
FIG. 8 is a graph illustrating the resistance of the graphene channel depending on the gate voltage according to the present invention;
FIG. 9 is a graph illustrating the frequency of the 2D Raman mode of graphene as a function of the frequency of the G Raman mode of the transferred graphene according to the present invention.

### DETAILED DESCRIPTION OF THE INVENTION

While the invention is susceptible of various modifications and alternative constructions, some preferred embodiments are shown in the drawings and will be described in detail hereinbelow.

It should be understood, however, that there is no intention to limit the invention to the illustrated specific embodiments, but, on the contrary, the invention is intended to cover all the modifications, alternative constructions, and equivalents falling within the scope of the invention as defined in the claims.

In the following description, therefore, the use of "for example", "etc.", "or" means non-exclusive alternatives without any limitation, unless otherwise indicated; the use of "also" means "including, but not limited to" unless otherwise indicated; the use of "includes/comprises" means "includes/comprises, but not limited to" unless otherwise indicated.

The present invention is based on the innovative concept of combining two polymers and an elastomeric frame.

The invention consists of a bilayer polymeric membrane supported by an elastomeric frame and the relevant method of use, based on the exploitation of the thermal and mechanical characteristics of different polymers and elastomers, which allow to perform a perfect delamination without contamination and a lamination aligned and free from damages of two-dimensional materials from a sacrificial substrate, compatible with the wafer-scale processing.

In the present description, the term "two-dimensional material" means graphene, hexagonal boron nitride h-BN, transition metals dichalcogenides TMD and X-enes; in the present description the terms "two-dimensional material" and "graphene" are used without distinction, as synonyms.

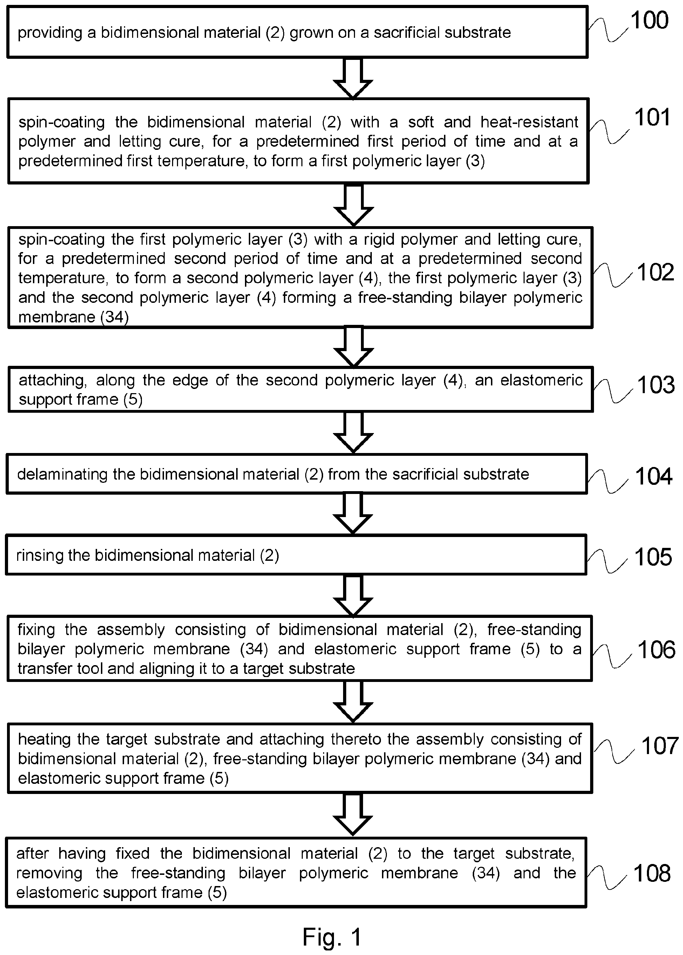

With reference to FIG. 1, a method for transferring a two-dimensional material onto a target substrate by means of a free-standing bilayer polymeric membrane 34 forms an aspect independent and autonomously usable with respect to the other aspects of the invention, which method comprising the following steps:
- providing a two-dimensional material 2 grown on a sacrificial substrate (step 100);
- spin-coating the two-dimensional material 2 with a soft and heat-resistant polymer and letting cure, for a predetermined first period of time and at a predetermined first temperature, to form a first polymeric layer 3 (step 101);
- spin-coating the first polymeric layer 3 with a rigid polymer and letting cure, for a predetermined second period of time and at a predetermined second temperature, to form a second polymeric layer 4, the first polymeric layer 3 and the second polymeric layer 4 forming a free-standing bilayer polymeric membrane 34 (step 102);
- attaching, along the edge of the second polymeric layer 4, an elastomeric support frame 5 (step 103);
- delaminating the two-dimensional material 2 from the sacrificial substrate (step 104);
- rinsing the two-dimensional material 2 (step 105);
- fixing the assembly consisting of two-dimensional material 2, free-standing bilayer polymeric membrane 34 and elastomeric support frame 5 to a transfer tool and aligning it to a target substrate (step 106);
- heating the target substrate and attaching thereto the assembly consisting of two-dimensional material 2, free-standing bilayer polymeric membrane 34 and elastomeric support frame 5 (step 107);
- after having fixed the two-dimensional material 2 to the target substrate, removing the free-standing bilayer polymeric membrane 34 and the elastomeric support frame 5 (step 108).

Preferably
- the two-dimensional material 2 is graphene;
- the soft and heat-resistant first polymeric layer 3 is made of polymethylmethacrylate PMMA, preferably it is made starting from a solution of PMMA ranging between 1% and 10% by weight in ethyl acetate, more preferably it is made starting from a solution of PMMA at 2% by weight in ethyl acetate acetate (quantity of ethyl acetate in the range 50-200 µL, preferably 100 µL for a surface of 1 cm²; it should be noted that the quantity ranges upon need, however maintaining the percentage concentration and assuring the recoating;
- the rigid second polymeric layer 4 is made of a material selected from polycarbonate PC and polypropylene carbonate PPC, preferably it is made of polypropylene carbonate PPC, more preferably it is made starting from a solution of PPC ranging between 10% and 20% by weight in anisole; still more preferably it is made starting from a solution of PPC at 15% by weight in anisole (quantity of anisole in the range 50-200 µL, preferably 100 µL for a surface of 1 cm²; it should be noted that the quantity ranges upon need, however maintaining the percentage concentration and assuring the recoating);
- the elastomeric support frame 5 is made of a material selected from the polysiloxanes, preferably it is made of polydimethylsiloxane PDMS.

Preferably
- the predetermined first period of time ranges between 2 minutes and 4 minutes and the predetermined first temperature ranges between 90 °C and 105 °C, more preferably the predetermined first period of time is equal to 2 minutes and the predetermined first temperature is equal to 90 °C;
- the predetermined second period of time ranges between 2 minutes and 4 minutes and the predetermined second temperature ranges between 90 °C and 105 °C, more preferably the predetermined second period of time is equal to 2 minutes and the predetermined second temperature is equal to 90 °C.

Preferably the delamination of the two-dimensional material 2 from the sacrificial substrate takes place in an aqueous solution, preferably in a solution of NaOH. Preferably the rinsing of the two-dimensional material 2 takes place by making it to float on the surface of deionized water.

Preferably the target substrate is heated to a temperature ranging between 90 °C and 105 °C, preferably at 90 °C.

Preferably the removal takes place sequentially
- first, mechanically, the elastomeric support frame 5 is removed;
- subsequently, the removal of the free-standing bilayer polymeric membrane 34 is carried out by immersion in a solvent, preferably in acetone, and it is optionally followed by soaking in a solvent, preferably in AR600-71.

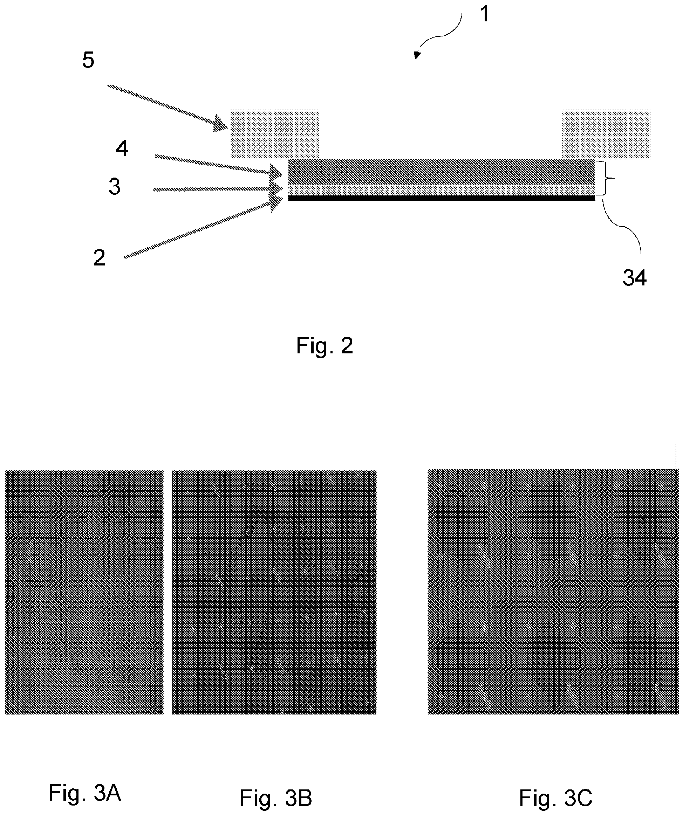

With reference to FIG. 2, a multilayer product 1 forms an aspect independent and autonomously usable with respect to the other aspects of the invention, which product comprising:
- a free-standing bilayer polymeric membrane 34 comprising
   a soft and heat-resistant first polymeric layer 3, and
   a rigid second polymeric layer 4, and
- an elastomeric support frame 5.

Preferably
- the soft and heat-resistant first polymeric layer 3 is made of polymethylmethacrylate PMMA, preferaby it is made starting from a solution of PMMA ranging between 1% and 10% by weight in ethyl acetate, more preferably it is made starting from a solution of PMMA at 2% by weight in ethyl acetate;
- the rigid second polymeric layer 4 is made of a material selected from polycarbonate PC and polypropylene carbonate PPC, preferably it is made of polypropylene carbonate PPC, more preferably it is made starting from a solution of PPC ranging between 10% and 20% by weight in anisole; even more preferably it is made starting from a solution of PPC at 15% by weight in anisole;
- the elastomeric support frame 5 is made of a material selected from the polysiloxanes, preferably it is made of polydimethylsiloxane PDMS.

Preferably
- the first polymeric layer 3 has a thickness ranging from 50 nm to 200 nm, preferably it is equal to 100 nm;
- the second polymeric layer 4 has a thickness ranging between 500 nm and 3 µm, preferably it is equal to 1.7 µm;
- the elastomeric support frame 5 has dimensions variable up to 5×5 cm², preferably has dimensions equal to 12×12 mm².

In detail, to obtain this membrane, a two-dimensional material previously grown on a sacrificial substrate is spin-coated with a solution of PMMA or of a polymer with similar thermal characteristics.

According to a preferred embodiment, this heat resistant polymer is PMMA and the starting solution is PMMA in ethyl acetate; PMMA may be present in the solution in a range of percentage by weight between 1% and 10 %.

According to a preferred embodiment, PMMA is present in the solution at a percentage by weight of 2%.

The final layer of PMMA on the assembly two-dimensional material / sacrificial substrate has a thickness ranging between some tens of nm and hundreds of nm. According to a preferred embodiment, the thickness of the PMMA layer is 100 nm. This layer requires a hardening process for a certain amount of time, preferably between 2 minutes and 4 minutes, at a certain temperature, preferably between 90 °C and 105 °C.

According to a preferred embodiment, the hardening takes place at 90 °C for 2 minutes.

Subsequently, a spin-coating id carried out with a solution of PPC or of a polymer with similar rigidity, such as PC.

According to a preferred embodiment, this rigid polymeric support is PPC and the starting solution is PPC in anisole; PPC can be present in the solution in a range of percentage by weight between 10% and 20%.

According to a preferred embodiment, PPC is present in the solution at a percentage by weight of 15%.

In the case of PC, on the other hand, the starting solution consists of PC in chloroform with a percentage by weight of 2% (quantity of chloroform in the range 50-200 µL, preferably 100 µL for a surface of 1 cm²; it is to be noted that the amount ranges upon need, however maintaining the percentage concentration and assuring the recoating). The final preferred PPC layer has a thickness ranging between some hundred nm and a few µm.

According to a preferred embodiment, the thickness of the PPC layer is 1.7 µm.

This layer requires a hardening process for a certain amount of time, preferably between 2 minutes and 4 minutes, at a certain temperature, preferably between 90 °C and 105 °C.

According to a preferred embodiment, the hardening takes place at 90 °C for 2 minutes.

The same parameters can be considered suitable for any alternative polymer. Subsequently, an elastomeric frame is attached around the edge; preferably such elastomeric frame is made of PDMS.

The PDMS elastomeric frame is hardened, preferably by oven curing, inside an aluminum shape so as to have the reticular structure; curing takes place at a temperature from 75 to 85 °C; according to a preferred embodiment, 10 g of PDMS are placed inside a single mold and it is possible to obtain, with the same mold, nine frames.

This frame can have dimensions up to 5x5 cm², with typical dimensions of 12x12 mm². The PDMS frame is typically hardened inside an aluminum mold and it is subsequently attached to the polymeric membrane.

The delamination of the assembly two-dimensional material / support body from the growth substrate occurs in an aqueous solution.

In the case of metals, the delamination can be activated by an alkaline electrolyte. Preferably, the delamination can be electrochemically activated in an electrolyte 1M NaOH, by applying few volts with respect to the counter-electrode; preferably, the applied voltage is -2.4V with respect to the counter-electrode (higher voltages could damage the graphene layer, thwarting the process).

The lower part of the membrane is then carefully rinsed by floating the membrane on the surface of deionized water.

The membrane is then connected to a transfer tool, such as a micrometric manipulator, and aligned in a precise way on the target substrate, which must be pre-heated to improve the adhesion with the functional layer; the heating can be carried out at a temperature between 90 °C and 105 °C, preferably at 90 °C.

After having fixed the membrane to the substrate, the polymers carriers are removed by immersion in a solvent and, for example acetone, while the PDMS is mechanically removed before the immersion in acetone.

Possible persistent polymer residues can be removed by further immersion in solvent AR600-71; such further immersion is preferably carried out at room temperature for some minutes, preferably for 3 minutes.

In detail, the growth of the graphene layer on the copper sacrificial substrate was carried out as described in the aforementioned scientific publication "Deterministic patterned growth of high-mobility large-crystal graphene: a path towards wafer-scale integration", Miseikis et al. 2017, 2D materials.

In particular, natively oxidized copper sheets were electropolished (Alfa-aesar, 99.8%, 13382) to clean the surface and to improve the surface morphology; the nucleation sites were then shaped on the sheet by optical lithography and thermal evaporation of 25 nm of chromium, followed by metal selective lift ("lift-off"); growth of large single crystals was performed by using a CVD growth procedure at low pressure (25 mbar) using a cold wall reactor Aixtron BM Pro; the copper substrates were annealed for 10 minutes in a non-reducing atmosphere of Argon Ar; the graphene was grown at a temperature of 1,060 °C with a gas stream comprising 900 standard cubic centimeters per minute (sccm) of Argon Ar, 100 sccm of hydrogen H₂ and 1 sccm of methane CH₄. The spin-coating and the hardening have been performed as described above: first PMMA (2% by weight in ethyl acetate; the amount of ethyl acetate is in the range 50-200 µL, preferably 100 µL for a surface of 1 cm²; it should be noted that the amount is variable upon need, however maintaining the percentage concentration and assuring the recoating) has been spin-coated on graphene / copper sheet and hardened at 90 °C for 2 minutes, then PPC (15% by weight in anisole; the amount of anisole is in the range 50-200 µL, preferably 100 µL for a surface of 1 cm²; it should be noted that the amount is variable upon need, however maintaining the percentage concentration and assuring the recoating) has been spin-coated on top of PMMA / graphene / copper sheet and hardened at 90 °C for 2 minutes.

In order to prove the effectiveness of the transfer method of two-dimensional materials and the corresponding multilayer product according to the present invention, tests have been carried out.

A comparison was carried out between a matrix of graphene transferred with only PMMA and with the new bilayer membrane PMMA / PPC with PDMS frame according to the present invention: the results are shown in FIGs. 3A, 3B and 3C.

As shown in FIGs. 3A and 3B, graphene undergoes mechanical damages during delamination using only the PMMA membrane, resulting in a low yield of the single crystal transfer technology.

On the contrary, as shown in FIG. 3 C, the new bilayer membrane PMMA / PPC with PDMS frame provides a rigid support during the delamination process enabling a high-performance transfer.

The images of FIGs. 3A, 3B and 3C were taken using a Nikon optical microscope (5x and 20x objectives and red filter).

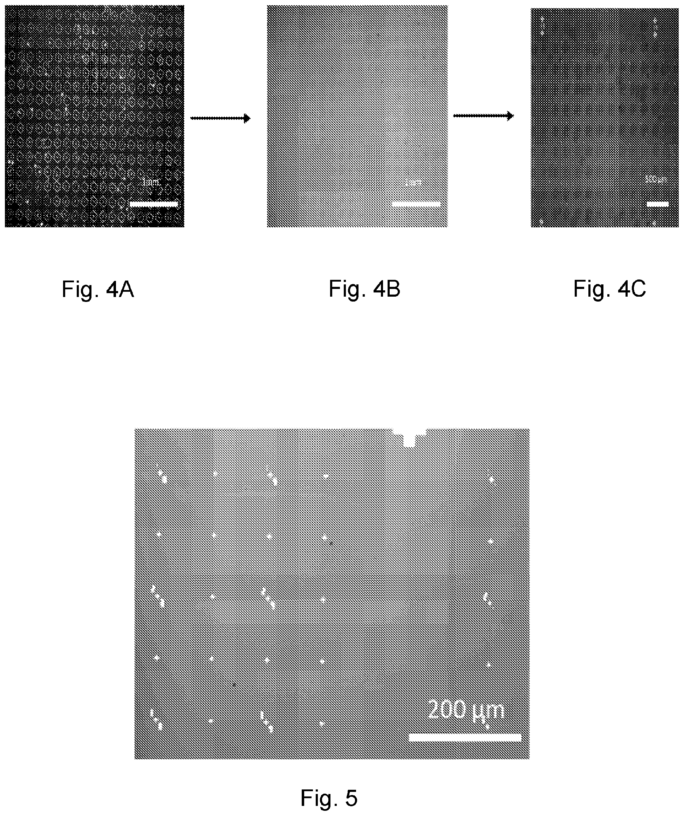

To demonstrate the reliability of the new transfer method according to the present invention, images have been recorded of the homogeneous graphene matrix at each step of the transfer process described above; such images, shown in FIGs. 4A, 4B and 4C, refer to the graphene layer in direct contact with the sacrificial copper substrate (FIG. 4A), to the graphene layer further in contact with the new membrane (FIG. 4B) and, finally, to the layer of graphene already transferred to the target substrate (FIG. 4C).

The images of FIG. 4 were recorded using a 5x objective of the Nikon optical microscope; the first image (FIG. 4A) is recorded in a dark field.

FIG. 5 refers to an optical microscopy image of a h-BN large monolayer transferred with the method and with the product PMMA / PPC / PDMS frame, in order to demonstrate the reliability of these method and product for the transfer of functional layer of another two-dimensional material; the h-BN used is commercially available and was provided by "Graphene supermarket".

The image of FIG. 5 was recorded using a 5x Nikon optical microscope.

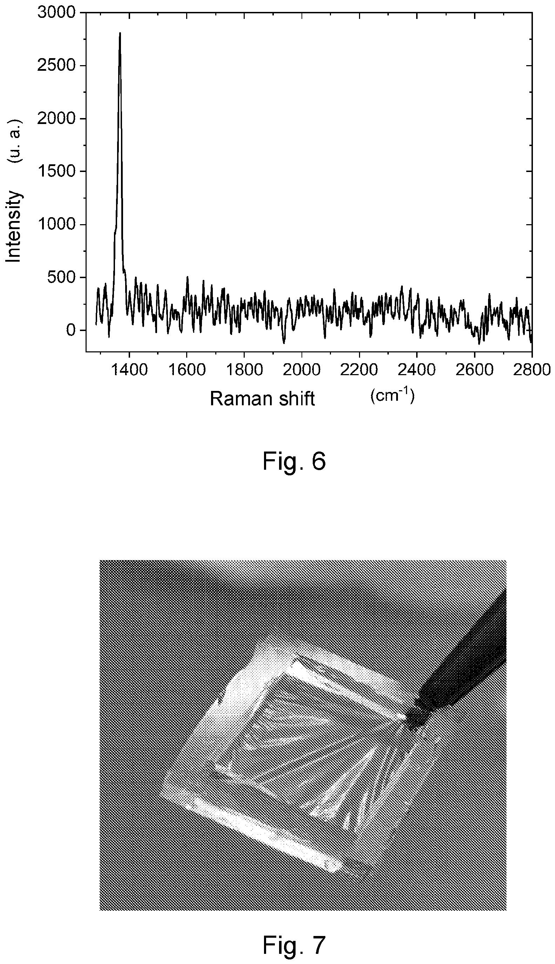

FIG. 6 shows the Raman spectrum of commercial h-BN after the transfer, acquired with a Renishaw InVia microscope using an excitation at 532 nm under ambient conditions, with a 50x objective.

The method of transferring two-dimensional materials and the corresponding multilayer product according to the present invention are described below in greater detail with reference to the following experimental tests, which are to be construed as illustrative but not limitative of the present invention.

Matrices of uniform graphene grown with success have been delaminated and transferred on various target wafer through the bilayer polymeric membrane with PDMS elastomeric support frame according to the present invention, as illustrated in FIG. 7.

In particular, such transferred functional layers have been employed in the manufacture of fifteen field-effect transistors ("Field Effect Transistors", FET) on a standard wafer of Si/SiO₂, showing a field effect mobility ("FE Mobility") equal to about 4,500 ± 450 cm²/Vs with a residual doping equal to approximately (6.3 ± 1.5) × 10¹¹ cm⁻².

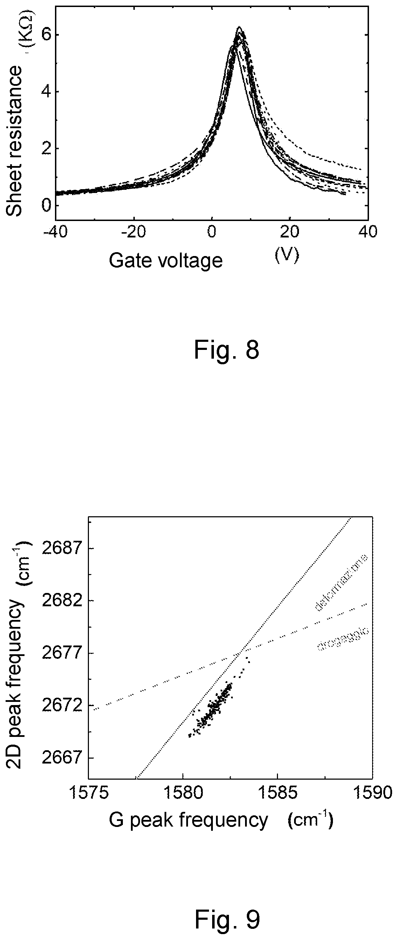

FIG. 8 refers to the effect the graphene electric field on the top portion of the transistors depending on the gate voltage applied (lower axis) and on the carrier density induced by the gate (upper axis).

FIG. 9 refers instead to the two-dimensional Raman frequency compared to the G frequency of the manufactured graphene transistors.

These graphs provide a direct visualization of the doping and deformation levels in the transferred material.

The close proximity of the point "cloud" at the intersection of the lines of deformation and doping, which denotes a non-deformed and undoped material, confirms the high quality of the transferred crystals.

The regulation used to extract the field effect mobility from the current and voltage data in FIG. 8 was performed as reported in the publication Kim et al. "Realization of a high mobility dual-gated graphene field-effect transistor with Al2O3 dielectric", Applied physics letters, 2009; mobility typical values of obtained for graphene grown on a copper sheet and transferred with other scalable transfer techniques are of approximately 1,000 cm²/Vs, as reported in the publication Boggild et al. "Mapping the electrical properties of large-area graphene", 2D materials, 2017.

The Raman spectra were acquired with a Renishaw InVia microscope using an excitation at 532 nm under ambient conditions, with a 50x objective.

Raman data were plotted in FIG. 9 following the procedure reported in the publication Banszerus et al. "Identifying suitable substrates for high-quality graphene-based heterostructures", 2D Materials, 2017 and confirm the small levels of doping and deformation after the transfer.

Transistors were manufactured after the transfer of graphene with the method described above on a substrate of SiO₂/Si (285 nm of SiO₂ on doped Si).

The transistor channel has been defined by electronic beam lithography and etched by reactive ion etching ("Reactive Ion Etching", RIE) (ratio Ar:O₂ equal to 80:5; pressure of 0,3 mbar; 25 W for 30 seconds); the source and drain contacts have been defined by electronic beam lithography and evaporation of Cr/Au (5/60 nm).

The retro-gate electrical measurements were carried out with an electrical probe station at room temperature and under ambient conditions.

As can be deduced from the above, the innovative technical solution herein described has the following advantageous features:
- transfer of monocrystals of two-dimensional materials intact, low-doped, non-deformed and with high mobility in a well-defined scheme;
- reduction of the risk of tear and damage of the two-dimensional material;
- resistance to temperature;
- removal in common solvents without leaving significant residues;
- precise alignment to the target substrate and without damage of the crystals of the two-dimensional material;
- delamination of the two-dimensional material free from copper contamination;
- possibility of a wafer-scale processing;
- high yield;
- applicability to a wide range of two-dimensional materials such as, for example, graphene, hexagonal boron nitride h-BN, transition metals dichalcogenides TMD and X-enes;
- conferment of the electronic properties - such as mobility of the bearers carrier, surface resistivity and density of the starting doping carrier - essential for the use in electronics, photonics, optoelectronics and spintronics;
- realization of modulators and detectors for telecom and datacom applications with record performances.

From the above description it is evident, therefore, how the method of transferring two-dimensional materials and the corresponding multilayer product according to the present invention allow to achieve the proposed objects.

It is equally evident to a person skilled in the art that it is possible to make modifications and further variations to the solution described with reference to the attached figures, within the scope of the invention as defined by the appended claims.

## Claims

1. Method for transferring a two-dimensional material (2) onto a target substrate by means of a free-standing bilayer polymeric membrane (34), comprising the following steps:
- providing a two-dimensional material (2) grown on a sacrificial substrate (step 100);
- spin-coating the two-dimensional material (2) with a soft and heat-resistant polymer and letting cure, for a predetermined first period of time and at a predetermined first temperature, to form a first polymeric layer (3) (step 101);
- spin-coating the first polymeric layer (3) with a rigid polymer and letting cure, for a predetermined second period of time and at a predetermined second temperature, to form a second polymeric layer (4), the first polymeric layer (3) and the second polymeric layer (4) forming a free-standing bilayer polymeric membrane (34) (step 102);
- attaching, along the edge of the second polymeric layer (4), an elastomeric support frame (5) (step 103);
- delaminating the two-dimensional material (2) from the sacrificial substrate (step 104);
- rinsing the two-dimensional material (2) (step 105);
- fixing the assembly consisting of two-dimensional material (2), free-standing bilayer polymeric membrane (34) and elastomeric support frame (5) to a transfer tool and aligning it to a target substrate (step 106);
- heating the target substrate and attaching thereto the assembly consisting of two-dimensional material (2), free-standing bilayer polymeric membrane (34) and elastomeric support frame (5) (step 107);
- after having fixed the two-dimensional material (2) to the target substrate, removing the free-standing bilayer polymeric membrane (34) and the elastomeric support frame (5) (step 108).

2. Method according to claim 1, wherein
- the two-dimensional material (2) is graphene;
- the soft and heat-resistant first polymeric layer (3) is made of polymethylmethacrylate PMMA, preferably it is made starting from a solution of PMMA ranging between 1% and 10% by weight in ethyl acetate, more preferably it is made starting from a solution of PMMA at 2% by weight in ethyl acetate;
- the rigid second polymeric layer (4) is made of a material selected from polycarbonate PC and polypropylene carbonate PPC, preferably it is made of polypropylene carbonate PPC, more preferably it is made starting from a solution of PPC ranging between 10% and 20% by weight in anisole; still more preferably it is made starting from a solution of PPC at 15% by weight in anisole;
- the elastomeric support frame (5) is made of a material selected from the polysiloxanes, preferably it is made of polydimethylsiloxane PDMS.

3. Method according to claim 1 or 2, wherein
- the predetermined first period of time ranges between 2 minutes and 4 minutes and the predetermined first temperature ranges between 90 °C and 105 °C, preferably the predetermined first period of time is equal to 2 minutes and the predetermined first temperature is equal to 90 °C;
- the predetermined second period of time ranges between 2 minutes and 4 minutes and the predetermined second temperature ranges between 90 °C and 105 °C, preferably the predetermined second period of time is equal to 2 minutes and the predetermined second temperature is equal to 90 °C.

4. Method according to any of the preceding claims, wherein the delamination of the two-dimensional material (2) from the sacrificial substrate takes place in an aqueous solution, preferably in a solution of NaOH.

5. Method according to any of the preceding claims, wherein the rinsing of the two-dimensional material (2) takes place by making it to float on the surface of deionized water.

6. Method according to any of the preceding claims, wherein the target substrate is heated to a temperature ranging between 90 °C and 105 °C, preferably at 90 °C.

7. Method according to any of the preceding claims, wherein the removal takes place sequentially
- first, mechanically, the elastomeric support frame (5) is removed;
- subsequently, the removal of the free-standing bilayer polymeric membrane (34) is carried out by immersion in a solvent, preferably in acetone, and it is optionally followed by soaking in a solvent, preferably in AR600-71.

8. Multilayer product (1) comprising:
- a free-standing bilayer polymeric membrane (34) comprising
a soft and heat-resistant first polymeric layer (3) made of polymethylmethacrylate PMMA, and
a rigid second polymeric layer (4) made of a material selected from polycarbonate PC and polypropylene carbonate PPC, and
- an elastomeric support frame (5).

9. Multilayer product (1) according to claim 8, wherein
- the soft and heat-resistant first polymeric layer (3) is made starting from a solution of PMMA ranging between 1% and 10% by weight in ethyl acetate, preferably it is made starting from a solution of PMMA at 2% by weight in ethyl acetate;
- the rigid second polymeric layer (4) is made of polypropylene carbonate PPC, preferably it is made starting from a solution of PPC ranging between 10% and 20% by weight in anisole; more preferably it is made starting from a solution of PPC at 15% by weight in anisole;
- the elastomeric support frame (5) is made of a material selected from the polysiloxanes, preferably it is made of polydimethylsiloxane PDMS.

10. Multilayer product (1) according to claim 8 or 9, wherein
- the first polymeric layer (3) has a thickness ranging from 50 nm to 200 nm, preferably it is equal to 100 nm;
- the second polymeric layer (4) has a thickness ranging between 500 nm and 3 µm, preferably it is equal to 1.7 µm;
- the elastomeric support frame (5) has dimensions variable up to 5x5 cm², preferably has dimensions equal to 12x12 mm².

## Patentansprüche

1. Verfahren zum Übertragen eines zweidimensionalen Materials (2) auf ein Zielsubstrat mittels einer freistehenden zweischichtigen Polymermembran (34), umfassend die folgenden Schritte:
- Bereitstellen eines zweidimensionalen Materials (2), das auf einem Opfersubstrat gewachsen ist (Schritt 100);
- Schleuderbeschichten des zweidimensionalen Materials (2) mit einem weichen und hitzebeständigen Polymer und Aushärtenlassen für eine vorbestimmte erste Zeitdauer und bei einer vorbestimmten ersten Temperatur, um eine erste Polymerschicht (3) zu bilden (Schritt 101);
- Schleuderbeschichten der ersten Polymerschicht (3) mit einem starren Polymer und Aushärtenlassen für eine vorbestimmte zweite Zeitdauer und bei einer vorbestimmten zweiten Temperatur, um eine zweite Polymerschicht (4) zu bilden, wobei die erste Polymerschicht (3) und die zweite Polymerschicht (4) eine freistehende zweischichtige Polymermembran (34) bilden (Schritt 102);
- Anbringen eines elastomeren Stützrahmens (5) entlang des Rands der zweiten Polymerschicht (4) (Schritt 103);
- Delaminieren des zweidimensionalen Materials (2) von dem Opfersubstrat (Schritt 104);
- Spülen des zweidimensionalen Materials (2) (Schritt 105);
- Befestigen der aus zweidimensionalem Material (2), freistehender zweischichtiger Polymermembran (34) und elastomerem Stützrahmen (5) bestehenden Anordnung an einem Übertragungswerkzeug und Ausrichten derselben an einem Zielsubstrat (Schritt 106);
- Erhitzen des Zielsubstrats und Anbringen der aus zweidimensionalem Material (2), freistehender zweischichtiger Polymermembran (34) und elastomerem Stützrahmen (5) bestehenden Anordnung daran (Schritt 107);
- Entfernen der freistehenden zweischichtigen Polymermembran (34) und des elastomeren Stützrahmens (5), nachdem das zweidimensionale Material (2) an dem Zielsubstrat befestigt wurde (Schritt 108).

2. Verfahren nach Anspruch 1, wobei
- das zweidimensionale Material (2) Graphen ist;
- die weiche und hitzebeständige erste Polymerschicht (3) aus Polymethylmethacrylat PMMA besteht, vorzugsweise ist sie ausgehend von einer Lösung von PMMA im Bereich zwischen 1 und 10 Gew.-% in Ethylacetat hergestellt, stärker bevorzugt ist sie ausgehend von einer Lösung von PMMA mit 2 Gew.-% in Ethylacetat hergestellt;
- die starre zweite Polymerschicht (4) aus einem Material hergestellt ist, das aus Polycarbonat PC und Polypropylencarbonat PPC ausgewählt ist, vorzugsweise ist sie aus Polypropylencarbonat PPC hergestellt, stärker bevorzugt ist sie ausgehend von einer Lösung von PPC im Bereich zwischen 10 und 20 Gew.-% in Anisol hergestellt; noch bevorzugter ist sie ausgehend von einer Lösung von PPC mit 15 Gew.-% in Anisol hergestellt;
- der elastomere Stützrahmen (5) aus einem Material hergestellt ist, das aus den Polysiloxanen ausgewählt ist, vorzugsweise ist er aus Polydimethylsiloxan PDMS hergestellt.

3. Verfahren nach Anspruch 1 oder 2, wobei
- die vorgegebene erste Zeitdauer zwischen 2 Minuten und 4 Minuten liegt und die vorgegebene erste Temperatur zwischen 90 °C und 105 °C liegt, vorzugsweise ist die vorgegebene erste Zeitdauer gleich 2 Minuten und die vorgegebene erste Temperatur ist gleich 90 °C;
- die vorgegebene zweite Zeitdauer zwischen 2 Minuten und 4 Minuten liegt und die vorgegebene zweite Temperatur zwischen 90 °C und 105 °C liegt, vorzugsweise ist die vorgegebene zweite Zeitdauer gleich 2 Minuten und die vorgegebene zweite Temperatur ist gleich 90 °C;

4. Verfahren nach einem der vorhergehenden Ansprüche, wobei die Delaminierung des zweidimensionalen Materials (2) von dem Opfersubstrat in einer wässrigen Lösung, vorzugsweise in einer Lösung von NaOH, stattfindet.

5. Verfahren nach einem der vorhergehenden Ansprüche, wobei das Spülen des zweidimensionalen Materials (2) stattfindet, indem es auf der Oberfläche von entsalztem Wasser zum Schwimmen gebracht wird.

6. Verfahren nach einem der vorhergehenden Ansprüche, wobei das Zielsubstrat auf eine Temperatur im Bereich zwischen 90 °C und 105 °C, vorzugsweise auf 90 °C, erhitzt wird.

7. Verfahren nach einem der vorhergehenden Ansprüche, wobei das Entfernen sequentiell erfolgt
- zuerst wird der elastomere Stützrahmen (5) mechanisch entfernt;
- anschließend erfolgt das Entfernen der freistehenden zweischichtigen Polymermembran (34) durch Eintauchen in ein Lösungsmittel, vorzugsweise in Aceton, und gegebenenfalls folgt darauf ein Tränken in einem Lösungsmittel, vorzugsweise in AR600-71.

8. Mehrschichtiges Produkt (1), umfassend:
- eine freistehende zweischichtige Polymermembran (34), umfassend
▪ eine weiche und hitzebeständige erste Polymerschicht (3), die aus Polymethylmethacrylat PMMA hergestellt ist, und
▪ eine starre zweite Polymerschicht (4), die aus einem Material, ausgewählt aus Polycarbonat PC und Polypropylencarbonat PPC, hergestellt ist, und
- einen elastomeren Stützrahmen (5).

9. Mehrschichtiges Produkt (1) nach Anspruch 8, wobei
- die weiche und hitzebeständige erste Polymerschicht (3) ausgehend von einer Lösung von PMMA im Bereich zwischen 1 und 10 Gew.-% in Ethylacetat hergestellt ist, bevorzugt ist sie ausgehend von einer Lösung von PMMA mit 2 Gew.-% in Ethylacetat hergestellt;
- die starre zweite Polymerschicht (4) aus Polypropylencarbonat PPC hergestellt ist, vorzugsweise ist sie ausgehend von einer Lösung von PPC im Bereich zwischen 10 und 20 Gew.-% in Anisol hergestellt; stärker bevorzugt ist sie ausgehend von einer Lösung von PPC mit 15 Gew.-% in Anisol hergestellt;
- der elastomere Stützrahmen (5) aus einem Material hergestellt ist, das aus den Polysiloxanen ausgewählt ist, vorzugsweise ist er aus Polydimethylsiloxan PDMS hergestellt.

10. Mehrschichtiges Produkt (1) nach Anspruch 8 oder 9, wobei
- die erste Polymerschicht (3) eine Dicke im Bereich von 50 nm bis 200 nm aufweist, vorzugsweise ist sie gleich 100 nm;
- die zweite Polymerschicht (4) eine Dicke im Bereich zwischen 500 nm und 3 µm aufweist, vorzugsweise ist sie gleich 1,7 µm;
- der elastomere Stützrahmen (5) Abmessungen aufweist, die bis zu 5 × 5 cm²variabel sind, vorzugsweise weist er Abmessungen gleich 12 × 12 mm² auf.

## Revendications

1. Procédé de transfert d'un matériau bidimensionnel (2) sur un substrat cible au moyen d'une membrane polymère bicouche autoportante (34), comprenant les étapes suivantes :
- fourniture d'un matériau bidimensionnel (2) développé sur un substrat sacrificiel (étape 100) ;
- revêtement par centrifugation du matériau bidimensionnel (2) avec un polymère souple et résistant à la chaleur et le fait de laisser durcir, pendant une première période de temps prédéterminée et à une première température prédéterminée, pour former une première couche polymère (3) (étape 101) ;
- revêtement par centrifugation de la première couche polymère (3) avec un polymère rigide et le fait de laisser durcir, pendant une seconde période de temps prédéterminée et à une seconde température prédéterminée, pour former une seconde couche polymère (4), la première couche polymère (3) et la seconde couche polymère (4) formant une membrane polymère bicouche autoportante (34) (étape 102) ;
- fixation, le long du bord de la seconde couche polymère (4), d'un cadre de support élastomère (5) (étape 103) ;
- délaminage du matériau bidimensionnel (2) du substrat sacrificiel (étape 104) ;
- rinçage du matériau bidimensionnel (2) (étape 105) ;
- fixation de l'ensemble constitué d'un matériau bidimensionnel (2), d'une membrane polymère bicouche autoportante (34) et d'un cadre de support élastomère (5) à un outil de transfert et alignement sur un substrat cible (étape 106) ;
- chauffage du substrat cible et fixation sur celui-ci de l'ensemble constitué d'un matériau bidimensionnel (2), de la membrane polymère bicouche autoportante (34) et d'un cadre de support élastomère (5) (étape 107) ;
- après avoir fixé le matériau bidimensionnel (2) au substrat cible, retrait de la membrane polymère bicouche autoportante (34) et du cadre de support élastomère (5) (étape 108).

2. Procédé selon la revendication 1, dans lequel
- le matériau bidimensionnel (2) est du graphène ;
- la première couche polymère souple et résistante à la chaleur (3) est constituée de polyméthacrylate de méthyle PMMA, de préférence elle est réalisée à partir d'une solution de PMMA comprise entre 1 % et 10 % en poids dans de l'acétate d'éthyle, plus préférablement elle est réalisée à partir d'une solution de PMMA à 2 % en poids dans de l'acétate d'éthyle ;
- la seconde couche polymère rigide (4) est constituée d'un matériau choisi parmi le polycarbonate PC et le polypropylène carbonate PPC, de préférence elle constituée de polypropylène carbonate PPC, plus préférablement elle est réalisée à partir d'une solution de PPC comprise entre 10 % et 20 % en poids dans de l'anisole ; encore plus préférablement elle est réalisée à partir d'une solution de PPC à 15 % en poids dans de l'anisole ;
- le cadre de support élastomère (5) est constitué d'un matériau choisi parmi les polysiloxanes, de préférence il est constitué de polydiméthylsiloxane PDMS.

3. Procédé selon la revendication 1 ou 2, dans lequel
- la première période de temps prédéterminée est comprise entre 2 minutes et 4 minutes et la première température prédéterminée est comprise entre 90 °C et 105 °C, de préférence la première période de temps prédéterminée est égale à 2 minutes et la première température prédéterminée est égale à 90 °C ;
- la seconde période de temps prédéterminée est comprise entre 2 minutes et 4 minutes et la seconde température prédéterminée est comprise entre 90 °C et 105 °C, de préférence la seconde période de temps prédéterminée est égale à 2 minutes et la seconde température prédéterminée est égale à 90 °C ;

4. Procédé selon l'une quelconque des revendications précédentes, dans lequel le délaminage du matériau bidimensionnel (2) du substrat sacrificiel a lieu dans une solution aqueuse, de préférence dans une solution de NaOH.

5. Procédé selon l'une quelconque des revendications précédentes, dans lequel le rinçage du matériau bidimensionnel (2) a lieu en le faisant flotter à la surface de l'eau déionisée.

6. Procédé selon l'une quelconque des revendications précédentes, dans lequel le substrat cible est chauffé à une température comprise entre 90 °C et 105 °C, de préférence à 90 °C.

7. Procédé selon l'une quelconque des revendications précédentes, dans lequel le retrait a lieu séquentiellement
- d'abord, mécaniquement, le cadre de support élastomère (5) est retiré ;
- ensuite, le retrait de la membrane polymère bicouche autoportante (34) est réalisé par immersion dans un solvant, de préférence dans de l'acétone, et il est éventuellement suivi d'un trempage dans un solvant, de préférence dans l'AR600-71.

8. Produit multicouche (1) comprenant :
- une membrane polymère bicouche autoportante (34) comprenant
▪ une première couche polymère souple et résistante à la chaleur (3) constituée de polyméthacrylate de méthyle PMMA, et
▪ une seconde couche polymère rigide (4) constituée d'un matériau choisi parmi le polycarbonate PC et le polypropylène carbonate PPC, et
- un cadre de support élastomère (5).

9. Produit multicouche (1) selon la revendication 8, dans lequel
- la première couche polymère souple et résistante à la chaleur (3) est réalisée à partir d'une solution de PMMA comprise entre 1 % et 10 % en poids dans de l'acétate d'éthyle, de préférence elle est réalisée à partir d'une solution de PMMA à 2 % en poids dans de l'acétate d'éthyle ;
- la seconde couche polymère rigide (4) est constituée de polypropylène carbonate PPC, de préférence elle est réalisée à partir d'une solution de PPC comprise entre 10 % et 20 % en poids dans de l'anisole ; plus préférablement elle est réalisée à partir d'une solution de PPC à 15 % en poids dans de l'anisole ;
- le cadre de support élastomère (5) est constitué d'un matériau choisi parmi les polysiloxanes, de préférence il est constitué de polydiméthylsiloxane PDMS.

10. Produit multicouche (1) selon la revendication 8 ou 9, dans lequel
- la première couche polymère (3) a une épaisseur allant de 50 nm à 200 nm, de préférence elle est égale à 100 nm ;
- la seconde couche polymère (4) a une épaisseur comprise entre 500 nm et 3 um, de préférence elle est égale à 1,7 um ;
- le cadre de support élastomère (5) a des dimensions variables jusqu'à 5x5 cm², de préférence a des dimensions égales à 12x12 mm².
